# EUROPÄISCHE PATENTSCHRIFT

(11) **EP 3 281 022 B1**
(45) Veröffentlichungstag und Bekanntmachung des Hinweises auf die Patenterteilung: **28.07.2021**
(21) Anmeldenummer: 16715527.4
(22) Anmeldetag: 08.04.2016
(51) Int. Cl.: G01R 27/08, G01R 31/42

(54) **ELEKTRISCHE BAUGRUPPE SOWIE MESSSCHALTUNG UND MESSVERFAHREN ZUR ÜBERWACHUNG EINES BAUELEMENTS DER ELEKTRISCHEN BAUGRUPPE**
ELECTRICAL ASSEMBLY AND MEASURING CIRCUIT AND MEASURING METHOD FOR MONITORING A COMPONENT OF THE ELECTRICAL ASSEMBLY
BLOC ÉLECTRIQUE AINSI QUE CIRCUIT DE MESURE ET PROCÉDÉ DE MESURE POUR LA SURVEILLANCE D'UN COMPOSANT DU BLOC ÉLECTRIQUE

(30) Priorität: 09.04.2015 DE 102015105354; 11.06.2015 DE 102015109285
(43) Veröffentlichungstag der Anmeldung: 14.02.2018
(73) Patentinhaber: Weidmüller Interface GmbH & Co. KG, 32758 Detmold (DE)
(72) Erfinder: PAIZ GATICA, Carlos, 32760 Detmold (DE); SCHINDLER, Rico, 32457 Porta Westfalica (DE)
(74) Vertreter: Kleine, Hubertus
(86) Internationale Anmeldenummer: PCT/EP2016/057823
(87) Internationale Veröffentlichungsnummer: WO 2016/162517

(56) Entgegenhaltungen:
- EP-A2- 0 652 445
- DE-A1-102012 112 901

## Beschreibung

Die Erfindung betrifft eine Messschaltung und ein Messverfahren zur Überwachung eines Bauelements einer elektrischen Baugruppe, sowie eine elektrische Baugruppe, insbesondere ein Schaltnetzteil, mit einer derartigen Messschaltung zur Durchführung des Messverfahrens.

In Schaltnetzteilen werden Kondensatoren sowohl primärseitig als auch sekundärseitig zur Glättung und Stabilisierung von Spannungen, insbesondere von gleichgerichteten Wechselspannungen, eingesetzt. In der Regel werden dafür Elektrolytkondensatoren verwendet, da diese über eine große Kapazität bei geringem Gewicht verfügen und verhältnismäßig kostengünstig sind. Die Kapazität von Kondensatoren, insbesondere von derartigen Elektrolytkondensatoren, nimmt mit zunehmender Zahl ihrer Betriebsstunden ab. Damit geht in der Regel ein Anstieg des inneren Widerstands, auch Ersatzserienwiderstand (ESR - Equivalent Series Resistor) genannt, einher.

Häufig sind diese Glättungs- und Stabilisierungskondensatoren eine Ursache von Ausfällen eines Schaltnetzteils und beeinträchtigen und begrenzen die Lebensdauer des Schaltnetzteils entscheidend. Der Alterungsvorgang der Kondensatoren verläuft in der Regel nicht gleichmäßig. Üblicherweise verstärkt sich eine zunächst geringe relative Kapazitätsabnahme bzw. geringe relative Zunahme des Ersatzserienwiderstands im Laufe der Zeit. Unterhalb einer bestimmten Kapazität bzw. oberhalb eines bestimmten Ersatzserienwiderstands des Kondensators ist das Schaltnetzteil nicht mehr betriebsfähig oder nur noch eingeschränkt belastbar. Um einen drohenden Ausfall eines Schaltnetzteils zu erkennen, bevor das Schaltnetzteil tatsächlich ausfällt, ist eine hinreichend genaue Bestimmung entweder der Kapazitätsabnahme oder der Zunahme des Ersatzserienwiderstands gefordert, mit der bereits eine kleine Abweichung gegenüber dem Ausgangszustand festgestellt werden kann.

Neben den Kondensatoren stellen die Halbleiterschalter des Schaltnetzteils, insbesondere der primärseitig verwendete getaktete Halbleiterschalter des Schaltwandlers, eine häufige Ursache für einen Ausfall eines Schaltnetzteils dar. Als getaktete Halbleiterschalter werden typischerweise Feldeffekttransistoren, insbesondere Metalloxid Halbleiter-Feldeffekttransistoren (MOSFETs - Metal Oxid Semiconductor Field-Effect Transistors) verwendet.

Durch Ladungsträgerdiffusionsprozesse und/oder durch Grenzflächenänderungen, die durch dauerhaft hohe Temperaturen bedingt sind, ändert sich der Durchgangswiderstand des Feldeffekttransistors im leitenden Zustand im Laufe der Zeit. Eine Erhöhung dieses Durchgangswiderstands im leitenden Zustand hat eine erhöhte Verlustleistung im Transistor und damit eine weitere Temperaturerhöhung zur Folge, was den Alterungsprozess wiederum beschleunigt. Aus diesem Grund erfolgt der Alterungsprozess bei Feldeffekttransistoren ähnlich wie bei den Kondensatoren nicht linear, sondern sich selbst beschleunigend. Entsprechend ist auch hier eine frühzeitige Erkennung von Änderungen des Durchgangswiderstands eines Feldeffekttransistors im leitenden Zustand wünschenswert, um einen bevorstehenden Ausfall rechtzeitig vorhersagen zu können, bevor es tatsächlich zu dem Ausfall kommt.

Sowohl die Bestimmung des Durchgangswiderstands eines Halbleiterschalters oder eines Ersatzserienwiderstands eines Kondensators, als auch eine Bestimmung der Kapazität des Kondensators beruht auf einer Messung von Spannung und Strom. Bei der Kapazitätsbestimmung ist der in einen Kondensator fließende Strom über die Kapazität des Kondensators mit der Spannungsänderung über den Kondensator verknüpft. Bei der Bestimmung des Ersatzserienwiderstands des Kondensators bzw. des Durchgangswiderstands des Halbleiterschalters ergibt sich dieser Widerstand als Quotient aus anliegender Spannung und fließendem Strom.

Eine derartige Messung von Strom und Spannung an einem Elektrolytkondensator zur Bestimmung und Überwachung seiner Kapazität ist beispielsweise aus der Druckschrift EP 0 652 445 A2 bekannt. Der Elektrolytkondensator wird dabei innerhalb eines Umrichters zur Umwandlung von Gleich- in Wechselspannung als Energiespeicher für die Umwandlung eingesetzt. Auch die Druckschrift DE 10 2012 112 901 A1 beschreibt eine Kapazitätsmessung für einen Kondensator anhand von Strom- und Spannungsmessungen.

Für die genannte Bestimmung von Ersatzserienwiderstand, Durchgangswiderstand oder Kapazität ist für jedes zu überwachende Bauelement eine Messung der Spannung und des Stroms erforderlich. Schaltnetzteile werden mit einer Taktfrequenz im Bereich von vielen 10-100 kHz (Kilo-Hertz) betrieben. Mit dieser Taktfrequenz ändern sich die Spannungen und Ströme an den zu untersuchenden Bauelementen. Da sich die Messwerte periodisch mit der Schaltfrequenz des Schaltnetzteils ändern, werden gemäß dem Stand der Technik die miteinander zu verrechnenden Spannungs- und Stromwerte gleichzeitig gemessen. Das erfordert pro Bauelement jeweils eine Messeinrichtung, beispielsweise einen A/D (Analog/Digital)-Wandler für die Spannung sowie einen weiteren für den Stromwert. A/D-Wandler mit geeigneten Spezifikationen hinsichtlich ihrer Geschwindigkeit sind kostenintensive Bauelemente. Um beispielsweise bei einem Schaltnetzteil einen primärseitigen Kondensator, den primärseitigen Halbleiterschalter und zwei sekundärseitige Kondensatoren zu überwachen, wären jeweils zwei derartige A/D-Wandler pro Bauelement, insgesamt also acht derartiger Wandler erforderlich.

Es ist eine Aufgabe der vorliegenden Erfindung, eine Messschaltung und ein Messverfahren zur Überwachung von Bauelementen einer elektrischen Baugruppe anzugeben, bei denen eine Überwachung des Alterungszustands mithilfe einer Spannungs- und Strommessung mit möglichst geringem Bauteile-Aufwand und damit kostengünstig erfolgen kann. Es ist eine weitere Aufgabe, eine elektrische Baugruppe mit einer derartigen Messschaltung zu beschreiben.

Diese Aufgabe wird gelöst durch eine Messschaltung und ein Messverfahren sowie eine elektrische Baugruppe mit den jeweiligen Merkmalen der unabhängigen Ansprüche. Vorteilhafte Ausgestaltungen und Weiterbildungen sind in den abhängigen Ansprüchen angegeben.

Eine erfindungsgemäße Messschaltung der eingangs genannten Art weist einen Analog/Digital-Wandler auf, der über einen Multiplexer wahlweise zur Messung von Spannung über mindestens einem Bauelement und zur Messung von Strom durch das Bauelement mit der elektrischen Baugruppe verbunden ist. Durch den Multiplexer können mit nur einem Analog/Digital-Wandler, der eines der kostenintensivsten Bauelemente der Messschaltung ist, beide benötigten Messgrößen, Spannung und Strom, bestimmt werden. Dieses ist insbesondere dann vorteilhaft, wenn die Messschaltung in einem Schaltnetzteil verwendet wird, das eine Schaltfrequenz von mehreren 10 bis 100 kHz aufweist, da in einem solchen Fall der Analog/Digital-Wandler für eine kurze Messzeit ausgelegt sein muss und entsprechend aufwendig aufgebaut ist.

In einer vorteilhaften Ausgestaltung weist die Messschaltung eine dem Multiplexer vorgeschaltete Spannungsbegrenzungsschaltung zur Begrenzung einer Eingangsspannung auf einen Maximalwert auf. Diese Ausgestaltung ist insbesondre zur Messung des Durchgangswiderstands eines primären Halbleiterschalters eines Schaltnetzteils vorteilhaft. Über dem Halbleiterschalter liegen je nach Höhe der Netzspannung bis zu einigen hundert Volt an, wenn der Halbleiterschalter sperrt. Im durchgeschalteten Zustand fallen dagegen über dem Halbleiterschalter lediglich einige Millivolt bis etwa hundert Millivolt ab. Die Spannungsbegrenzungsschaltung verhindert, dass nachgeschaltete Komponenten der Messschaltung durch eine zu hohe Spannung zerstört oder gesättigt werden.

In einer weiteren vorteilhaften Ausgestaltung weist die Messschaltung eine Synchronisationseinrichtung auf, um Spannung und/oder Strom synchron mit einem periodischen Schaltsignal der elektrischen Baugruppe zu messen. Bevorzugt ist die Messschaltung dazu eingerichtet ist, Spannung und Strom in aufeinanderfolgenden Schaltperioden des periodischen Schaltsignals zu messen und einen Widerstandswert anhand von Messwerten für Spannung und Strom zu bestimmen, die zu vergleichbaren Zeitpunkten innerhalb der aufeinanderfolgenden Schaltperioden gemessen sind. Die Werte von Spannung und Strom sind in der Regel während einer Schaltperiode nicht konstant. Die Synchronisation stellt sicher, dass die Werte von Spannung und Strom, die in aufeinanderfolgenden Schaltperioden gemessen werden, zu gleichen Zeitpunkten innerhalb der Schaltperioden und erfasst werden. Die Messwerte werden so bei gleichen Bedingungen gemessen und können miteinander zu einem Widerstandswert verrechnet werden.

Eine erfindungsgemäße elektrische Baugruppe weist eine derartige Messschaltung zur Messung eines Widerstandswerts eines Bauelements der elektrischen Baugruppe während des Betriebs der elektrischen Baugruppe auf. Es ergeben sich die im Zusammenhang mit der Messschaltung genannten Vorteile.

In einer vorteilhaften Ausgestaltung der elektrischen Baugruppe ist diese als ein Schaltnetzteil mit einem Schaltwandler ausgebildet, wobei die Messschaltung zur Messung eines Widerstands eines Schalttransistors des Schaltwandlers eingerichtet ist. Bevorzugt ist die Messschaltung zusätzlich zur Messung eines Ersatzserienwiderstands eines Kondensators einer primären Siebstufe eingerichtet.

Ein erfindungsgemäßes Messverfahren zur Überwachung eines Bauelements einer elektrischen Baugruppe, bei dem eine Spannung über mindestens einem Bauelement der elektrischen Baugruppe und ein Strom durch das Bauelement gemessen werden und bei dem aus Messwerten für Spannung und Strom ein Widerstandswert des Bauelements bestimmt wird, ist dadurch gekennzeichnet, dass die Spannung und der Strom nacheinander in aufeinanderfolgenden Schaltperioden eines periodischen Schaltsignals der elektrischen Baugruppe gemessen werden und der Widerstandswert anhand der Messwerte für Spannung und Strom aus den aufeinanderfolgenden Schaltperioden ermittelt wird. Wiederum ergeben sich die im Zusammenhang mit der Messschaltung genannten Vorteile.

In einer vorteilhaften Ausgestaltung des Messverfahrens werden die Spannung und der Strom synchron mit dem periodischen Schaltsignal der elektrischen Baugruppe gemessen, wobei der Widerstandswert anhand von Messwerten für Spannung und Strom bestimmt wird, die zu vergleichbaren Zeitpunkten innerhalb der aufeinanderfolgenden Schaltperioden gemessen sind. Die Messwerte werden so bei gleichen Bedingungen gemessen und können miteinander zu einem Widerstandswert verrechnet werden. Diesem liegt die Erkenntnis zugrunde, dass die Messwerte zwar innerhalb einer Schaltperiode stark schwanken können, diese Schwankungen sich aber von einer Schaltperiode zu einer nächsten Schaltperiode nicht oder, z.B. bei einem Lastwechsel eines Schaltnetzteils, verglichen mit der Länge der Schaltperiode nur langsam ändern.

In einer weiteren vorteilhaften Ausgestaltung des Messverfahrens ist die elektrische Baugruppe ein Schaltnetzteil und das Bauelement ein Schalttransistor eines Schaltwandlers des Schaltnetzteils ist.

Die Erfindung wird nachfolgend anhand von Ausführungsbeispielen mithilfe von Figuren näher erläutert. Es zeigen:
- Fig. 1: einen schematischen Aufbau eines Schaltnetzteils, vorbereitet zur Verwendung mit einer anmeldungsgemäßen Messschaltung;
- Fig. 2: ein Blockschaltbild einer anmeldungsgemäßen Messschaltung;
- Fig. 3: ein detailliertes Schaltbild einer Spannungsbegrenzungsschaltung der Messschaltung der Fig. 2; und
- Fig. 4: ein Flussdiagramm eines anmeldungsgemäßen Messverfahrens.

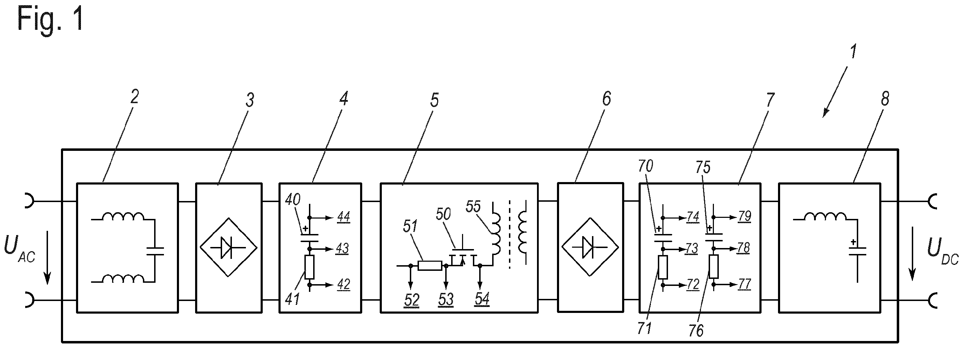

In Fig. 1 ist ein Blockschaltbild eines Schaltnetzteils 1 als Beispiel einer elektrischen Baugruppe dargestellt, das zur Verwendung mit einer anmeldungsgemäßen Messschaltung vorbereitet ist.

Das in Fig.1 dargestellte Schaltnetzteil 1 umfasst einen eingangsseitigen, an eine Netzspannung U_{AC} anzuschließenden Leistungsfaktorkorrekturfilter 2 (PFC - power factor correction), der beispielsweise als ein passiver Filter ausgeführt sein kann. Abhängig von der Leistung des Schaltnetzteils 1 ist auch ein aktiver Leistungsfaktorkorrekturfilter verwendbar. Mit dem Ausgang des Leistungsfaktorkorrekturfilters 2 ist ein primärseitiger Gleichrichter 3 verbunden, beispielsweise ein Brückengleichrichter.

Parallel zum Ausgang des primärseitigen Gleichrichters 3 ist eine primäre Siebstufe 4 geschaltet, die vorliegend einen primärseitigen Kondensator 40 aufweist. In Serienschaltung mit dem Kondensator 40 ist ein Shunt 41 geschaltet, der der Messung des Stroms, der durch den primären Kondensator 40 fließt, dient. Am primärseitigen Kondensator 40 bzw. am Shunt 41 sind Messpunkte 42-44 vorgesehen, die mit einer anmeldungsgemäßen Messschaltung verbunden werden. An den Messpunkten 43 und 44 kann die am Kondensator 40 anliegende Spannung, nachfolgend auch Kondensatorspannung U₄₀ genannt, gemessen werden. An den Messpunkten 42 und 43 kann die über dem Shunt 41 abfallende Spannung gemessen werden, aus der sich bei bekanntem Widerstandswert des Shunts 41 der durch den primärseitigen Kondensator 40 fließende Strom, nachfolgend Kondensatorstrom I₄₀ genannt, bestimmen lässt.

Parallel zur primären Siebstufe 4 ist ein Schaltwandler 5 angeordnet. Dieser umfasst einen Schalttransistor 50, der den Strom durch eine Primärspule eines Übertragers 55 angesteuert von einer hier nicht dargestellten Steuereinrichtung des Schaltnetzteils 1 getaktet schaltet. Zur Bestimmung des durch den Schalttransistor 50 fließenden Stroms ist dieser in Serie mit einem Shunt 51 verschaltet. Analog zu den Messpunkten 42-44 sind auch an der Serienschaltung vom Schalttransistor 50 und dem Shunt 51 Messpunkte 52-54 angeordnet. Sie erlauben, auf vergleichbare Weise wie im Zusammenhang mit der primären Siebstufe 4 erläutert, eine Messung von Spannung über der Schaltstrecke des Schalttransistors 50 sowie dem durch den Schalttransistor 50 fließenden Strom. Spannung und Strom am Schaltransistor werden nachfolgend Transistorspannung U₅₀ bzw. Transistorstrom I₅₀ genannt.

Der Übertrager 55 ist ein galvanisch trennender Übertrager, der Primärseite und Sekundärseite des Schaltnetzteils 1 elektrisch voneinander isoliert. Sekundärseitige Ausgänge des Übertragers 55 sind über einen sekundären Gleichrichter 6, beispielsweise einen Brückengleichrichter oder einen einfachen, durch nur eine Diode gebildeten Gleichrichter, mit einer sekundären Siebstufe 7 verbunden. Die sekundäre Siebstufe 7 umfasst im dargestellten Beispiel zwei Kondensatoren 70 und 75, denen zur Strommessung ebenfalls je ein Shunt 71 bzw. 76 in Serie geschaltet ist. Wiederum vergleichbar mit der primären Siebstufe 4 sind auch hier Messpunkte 72-74 bzw. 77-79 angeordnet, die eine Messung der Spannung am sekundären Kondensator 70 bzw. 75 sowie des durch ihn jeweils fließenden Stroms ermöglichen. Schließlich ist der sekundären Siebstufe 7 ein Filter 8 nachgeschaltet, an dessen Ausgang eine vom Schaltnetzteil 1 bereitgestellte Gleichspannung U_{DC} anliegt.

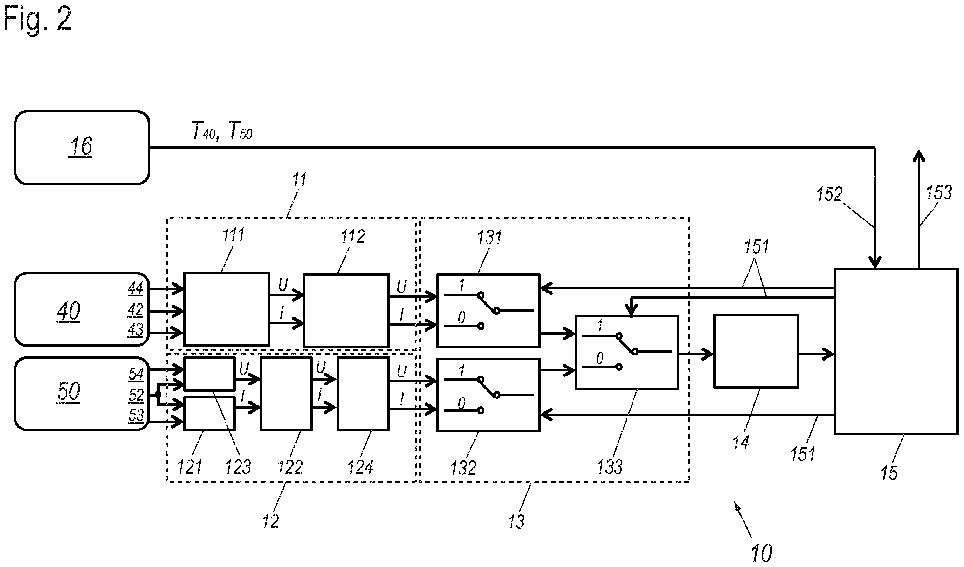

Fig. 2 zeigt ein Blockschaltbild einer primärseitigen Messschaltung 10. Die Messschaltung weist zwei Signalverarbeitungszweige 11, 12 auf, deren Eingänge jeweils mit den Messpunkten 42-44 der primären Siebstufe 4 bzw. den Messpunkten 52-54 des Schaltwandlers 5 verbunden sind. Über diese Messpunkte 42-44 bzw. 52-54 kann über den ersten Signalverarbeitungszweig 11 die Kondensatorspannung U₄₀ und der Kondensatorstrom I₄₀ und über den zweiten Signalverarbeitungszweig 12 die Transistorspannung U₅₀ und der Transistorstrom I₅₀ gemessen werden.

Im ersten Signalverarbeitungszweig 11 ist jeweils zur Spannungs- und Strommessung ein analoger Filter 111 angeordnet, der als Bandpassfilter auf die Schaltfrequenz des Schaltnetzteils 1 abgestimmt ist und die mit der Schaltfrequenz variierenden Messsignale passieren lässt. Der Filter 111 weist vorteilhaft eine Butterworth-Charakteristik 3. Ordnung auf. Er ist breitbandig ausgebildet, um auch trotz Bauteiltoleranzen und einer eventuell variierenden Schaltfrequenz des Schaltnetzteils 1 das Signal passieren zu lassen. An den Filter 111 schließt sich ein Verstärker 112 zur Signalverstärkung und ggf. Nullpunkt-Korrektur an.

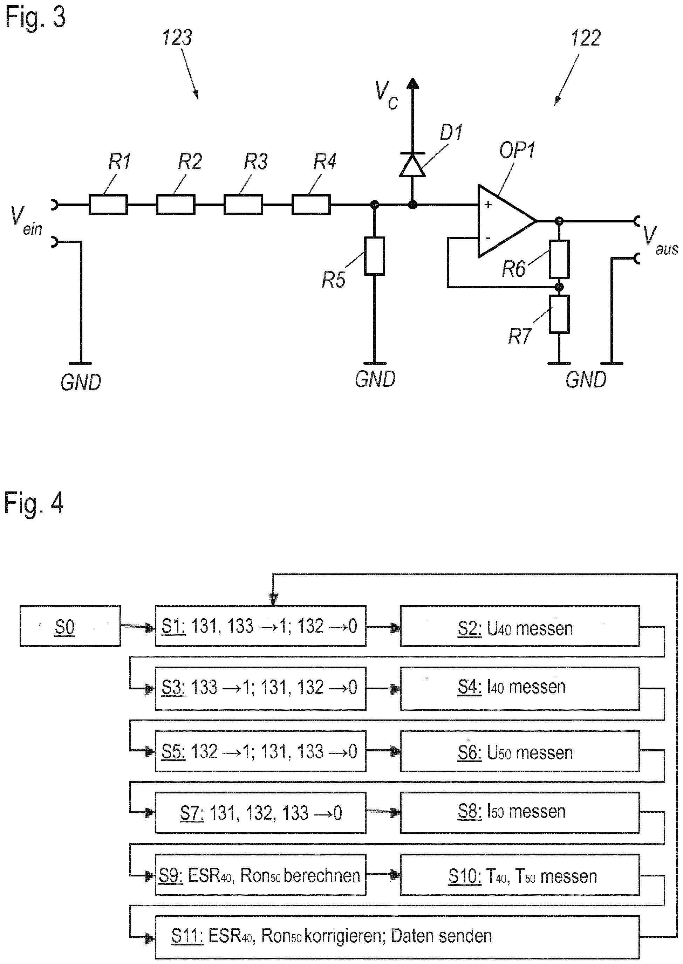

Im zweiten Signalverarbeitungszweig 12 ist zur Strommessung zunächst ein analoger Filter 121 angeordnet. Der Filter 121 ist mit dem Filter 111 im ersten Signalverarbeitungszweig 11 vergleichbar. Zur Spannungsmessung ist statt eines Filters eine Spannungsbegrenzungsschaltung 123 vorgesehen, die im Zusammenhang mit Fig. 3 näher erläutert wird. An den Filter 121 bzw. die Spannungsbegrenzungsschaltung 123 schließt sich wiederum jeweils ein Verstärker 122 an. Zusätzlich kann optional im Signalverarbeitungszweig noch ein Synchronisationsschalter 124 angeordnet sein, der im Takt des Schalttransistors 50 angesteuert wird und die Messsignale nur in der Anschaltphase des Schalttransistors 50 durchlässt.

Ein Ausführungsbeispiel einer Spannungsbegrenzungsschaltung 123 mit nachgeordnetem Verstärker 122 ist in Fig. 3 detaillierter dargestellt. Über dem Schalttransistor 50 liegen je nach Höhe der Netzspannung U_{AC} bis zu einigen hundert Volt an, wenn der Schalttransistor 50 sperrt. Im durchgeschalteten Zustand fallen dagegen über dem Schalttransistor 50 lediglich einige Millivolt bis etwa hundert Millivolt ab. Die Spannungsbegrenzungsschaltung 123 verhindert, dass nachgeschaltete Komponenten der Messschaltung durch eine zu hohe Spannung zerstört oder gesättigt werden.

An Eingängen wird der Spannungsbegrenzungsschaltung 123 die zu messende Eingangsspannung Vₑᵢₙ zugeführt, beispielsweise von den Messpunkten 53 und 54. Alternativ kann die Spannungsmessung auch an den Messpunkten 52 und 54 erfolgen, wobei der mitgemessene Spannungsabfall über dem Shunt 51 später abgezogen wird. Letzteres ist vorteilhaft, da der Messpunkt 52 dann einen gemeinsamen Messpunkt für Spannung- und Strommessung darstellt.

Die Eingangsspannung Vₑᵢₙ wird zunächst in einem Spannungsteiler durch (hochohmige) Widerstände R1 bis R5 um einen Faktor, beispielsweise um den Faktor 5, geteilt. Der Ausgang des Spannungsteilers ist über eine Diode D1 mit einem kleinen positiven Potential V_{c} der Höhe von einigen Volt gegenüber einem Massepotential GND verbunden und wird dadurch auf dieses Potential (zuzüglich der Durchbruchsspannung der Diode D1) begrenzt (gepinnt). Spannungsteiler und das Potential V_{c} sind so gewählt, dass die Begrenzung für die hohe Spannung bei gesperrtem Schalttransistor 50 greift und die Spannung bei durchgeschaltetem Schalttransistor 50 unbeeinträchtigt lässt.

Am Ausgang des Spannungsteilers schließt sich der Verstärker 122 an, der hier durch einen Operationsverstärker OP1 mit Gegenkopplungswiderständen R6 und R7 gebildet ist. Der Verstärkungsfaktor des Verstärkers 122 ist so gewählt, dass der Verstärker die Spannungsteilung zumindest teilweise ausgleicht, aber auch bei gepinnter Spannung an seinem Eingang keine Sättigung auftritt. Im Resultat liegt an dem Ausgang des Verstärkers 122 eine Ausgangsspannung Vₐᵤₛ an, die bei gesperrtem Schalttransistor 50 auf einem konstanten Wert von einigen Volt gehalten ist und die bei durchgeschaltetem Schalttransistor 50 ohne nennenswerte Zeitverzögerung auf einen Wert abfällt, der proportional zur Spannung über dem durchgeschalteten Schalttransistor 50 ist.

Nach der Signalverarbeitung der Messwerte in den Signalverarbeitungszweigen 11, 12 werden die verarbeiteten Messwerte einem Multiplexer 13 zugeführt. Der Multiplexer 13 weist im dargestellten Ausführungsbeispiel drei kaskadierte Umschalter auf, einen ersten Umschalter 131, einen zweiten Umschalter 132 und einen dritten Umschalter 133. Die Stellung des ersten bzw. zweiten Umschalters 131, 132 legt fest, ob aus dem jeweiligen Signalverarbeitungszweig 11, 12 jeweils die Messwerte für Spannung oder Strom weiter gereicht werden. Der dritte Umschalter 133 wählt aus, ob der weitergereichte Messwert von entweder Spannung oder Strom aus dem ersten oder dem zweiten Signalverarbeitungszweig 11, 12 weitergeleitet wird. Die Umschalter 131, 132 und 133 werden von dem Mikrocontroller 15 über Steuerleitungen 151 angesteuert. Der Ausgang des Multiplexers 13 ist mit einem Eingang eines Analog/Digital (A/D)-Wandlers 14 verbunden. Dessen digitaler Ausgang wiederum wird von einem Mikrocontroller 15 eingelesen.

Der Mikrocontroller 15 steht zudem über einen Signaleingang 152 in Verbindung mit Temperatursensoren 16, über die der Mikrocontroller 15 eine Temperatur T₄₀ des primären Kondensators 40 und eine Temperatur T₅₀ des Schalttransistors 50 einlesen kann. Die entsprechenden Temperatursensoren stehen zu diesem Zweck in thermischem Kontakt mit dem jeweiligen Bauelement.

Der A/D-Wandler 14 ist ein Wandler mit einer hohen Abtastrate von bevorzugt einigen Megahertz (MHz). Die Abtastrate ist damit um ein Vielfaches größer als die typische Schaltfrequenz des überwachten Schaltwandlers, die im Bereich von einigen 10-100 kHz liegt. Der A/D-Wandler 14 wird über den Multiplexer 13 mit den verschiedenen Eingangssignalen beaufschlagt. Je nach Ansteuerung der Umschalter 131-133 werden von dem Mikrocontroller 15 die vom A/D-Wandler 14 empfangenen Daten den verschiedenen Messgrößen von Spannung und Strom des primären Kondensators 40 bzw. des Schalttransistors 50 zugeordnet.

Im Messablauf werden die Umschalter 131-133 des Multiplexers 13 so angesteuert, dass nacheinander jeweils eine Folge von Messpunkten für die Spannung U₄₀ und danach den Strom I₄₀ am bzw. durch den primären Kondensator 40 aufgenommen und danach jeweils eine Folge von Messpunkten für die Spannung U₅₀ und den Strom I₅₀ am bzw. durch den Schalttransistor 50. Dabei ist anmeldungsgemäß der Messablauf so ausgestaltet, dass er synchronisiert zum Schalttakt des Schalttransistors 50 des Schaltwandlers 5 erfolgt.

Dieser Programmablauf ist in Fig. 4 in einem Flussdiagramm wiedergegeben. Nach einer Initialisierung des Mikrocontrollers 15 in einem ersten Schritt S0 wird einem nächsten Schritt S1 der erste Umschalter 131 auf den Wert 1 und der dritte Umschalter 133 auf den Wert 1 gesetzt, sodass vom ersten Signalverarbeitungszweig 11 der Spannungsmesszweig mit dem A/D-Wandler 14 verbunden ist.

Danach wird in einem nächsten Schritt S2 - bevorzugt synchronisiert mit dem Schalttakt des Schalttransistors 50 - eine Anzahl an Messpunkten zur Messung der Kondensatorspannung U₄₀ am primären Siebkondensator 40 gemessen. Es kann vorgesehen sein, dass sich diese Messung über eine vorgegebene Anzahl von Schaltperioden des Schaltwandlers 5 erstreckt. Eine Synchronisierung kann dabei über eine Interrupt-Steuerung des Mikrocontrollers 15 mit dem Schaltsignal des Schalttransistors 50 erfolgen. Es kann alternativ auch vorgesehen sein, eine vorgegebene Anzahl von Messpunkten aufzunehmen und anschließend durch einen entsprechenden Algorithmus im Mikrocontroller 15 die Messpunkte anhand der erfassten Signalform der Messreihe auf eine oder mehrere Perioden zu beschränken. Dieses ist möglich, da sich das Messsignal periodisch mit der Schaltperiode des Schaltwandlers 5 ändert.

In einem nächsten Schritt S3 wird der erste Umschalter 131 auf den Wert 0 gesetzt, wobei der dritte Umschalter 133 auf dem Wert 1 verbleibt, sodass vom ersten Signalverarbeitungszweig 11 der Strommesszweig mit dem A/D-Wandler 14 verbunden ist. Danach wird in einem nächsten Schritt S4 - bevorzugt wieder synchronisiert mit dem Schalttakt des Schalttransistors 50 - eine Anzahl an Messpunkten zur Messung des Stroms I₄₀ durch den primären Kondensator 40 gemessen. Es kann wiederum vorgesehen sein, dass sich diese Messung über eine vorgegebene Anzahl von Schaltperioden des Schaltwandlers 4 erstreckt.

Strom und Spannung am Kondensator ändern sich in erster Näherung sinusförmig. Um einen Ersatzserienwiderstand ESR₄₀ des primären Kondensators 40 zu bestimmen, wird nachfolgend (vgl. Schritt S9) der Effektivwert der Änderung der Spannung U₄₀ und der Effektivwert des Stroms I₄₀ am primären Kondensator 40 anhand der Messwerte berechnet. Neben der analogen Filterung, die das Spannungssignal im Filter 111 erfahren hat, erfolgt im Mikrocontroller 15 zusätzlich eine digitale Signalfilterung. Für diese digitale Signalfilterung werden die aufgenommenen und sich über eine oder mehrere Perioden erstreckende Signalfolgen mehrfach hintereinander gehängt und einem digitalen Filter zugeführt. Auf diese Weise wird das Signal künstlich verlängert, sodass der digitale Filter sich einschwingen kann. Anhand des gefilterten Signals wird dann ein Effektivwert für die Spannungsänderung und den Strom am Kondensator 40 ermittelt. Der digitale Filter kann als ein adaptiver Filter ausgeführt sein, dessen Parameter sich nach einem vorgegebenen Algorithmus an die Messsignale anpassen. So kann beispielsweise eine schmalbandige Filterung auch bei variierenden Schaltfrequenzen des Schaltwandlers 5 erfolgen.

In einem nächsten Schritt S5 wird der dritte Umschalter 133 auf den Wert 0 gesetzt, sodass nunmehr Messwerte des zweiten Signalverarbeitungszweigs 12 erfasst werden. Der zweite Umschalter 132 wird auf den Wert 1 gesetzt, sodass vom zweiten Signalverarbeitungszweig 12 der Spannungsmesszweig mit dem A/D-Wandler 14 verbunden ist, um die Spannung U₅₀ über der Schaltstrecke des Schalttransistors 50 zu messen.

Im folgenden Schritt S6 werden bevorzugt Messdaten während einer Einschaltperiode des Schalttransistors gemessen, wobei wiederum eine Synchronisation mit den Schaltzeitpunkten des Schalttransistors 50 erfolgt. Auch hier kann die Synchronisation anhand einer Interrupt-Steuerung des Mikrocontrollers 15 erfolgen oder aus der Datenform ermittelt werden. Letzteres ist hier gut durchführbar, da die Spannung über dem Schalttransistor 50 zwischen seiner Ausschaltphase und seiner Einschaltphase stark variiert. Bedingt durch die Spannungsbegrenzungsschaltung 123 gemäß Fig. 3 liegen nur Messpunkte innerhalb der Einschaltphase unterhalb des vorbekannten maximalen Messwertes und können daher leicht identifiziert werden.

Nach der Spannungsmessung im Schritt S6 wird in einem Schritt S7 der zweite Umschalter 132 auf den Wert 0 gesetzt, während der dritte Umschalter 133 auf dem Wert 0 verbleibt, um nachfolgend in einem Schritt S8 eine Messfolge an Messpunkten für den Strom I₅₀ durch den Schalttransistor 50 aufzunehmen. Diese erfolgt wiederum synchronisiert mit dem Schalttakt des Schalttransistors 50 und bevorzugt in der unmittelbar auf die Spannungsmessung folgenden Einschaltphase der nächsten Schaltperiode des Schalttransistors 50.

An die Messungen schließt sich mit dem Schritt S9 eine Auswertung an, in der aus den Effektivwerten der Änderung der Kondensatorspannung U₄₀ und des Kondensatorstroms I₄₀ ein Wert für den Ersatzserienwiderstand ESR₄₀ des Kondensators 40 berechnet wird. Weiter wird aus Wertepaaren von Spannung U₅₀ und Strom I₅₀, die jeweils zu gleichen Zeitpunkten innerhalb der (aufeinanderfolgenden) Einschaltphasen gemessen wurden, ein Wert für den Einschaltwiderstand Ron₅₀ des Schalttransistors 50 berechnet.

In einem nächsten Schritt S10 werden die Temperaturen T₄₀ und T₅₀ des Kondensators 40 und des Schalttransistors 50 gemessen. Da diese Werte nicht zeitkritisch und nicht synchron zu einem Schalttakt erfasst werden müssen, kann hierfür ein interner A/D-Wandler im Mikrocontroller 15 eingesetzt werden. Die gemessenen Temperaturwerte werden in einem folgenden Schritt S11 eingesetzt, um die gemessenen Widerstandswerte (ESR₄₀, Ron₅₀) auf einen Vergleichswert bei einer festgelegten Temperatur zu korrigieren. Beide genannten Widerstandswerte sind stark temperaturabhängig. Eine Aussage über eventuelle Änderungen der Werte, die auf einen Alterungsprozess schließen lassen, kann nur dann erfolgen, wenn die Werte um Temperatureffekte bereinigt sind. Dieses kann anhand von Tabellen oder (parametrisierten) Temperaturkurven erfolgen, die im Mikrocontroller 15 hinterlegt sind.

Schließlich werden die berechneten und korrigierten Werte von ESR₄₀ und Ron₅₀ im Schritt S11 über den Datenausgang 153 ausgegeben, beispielsweise an eine übergeordnete Steuereinheit des Schaltnetzteils 1, in der ein Vergleich mit den ursprünglichen Werten erfolgt und durch den ggf. eine Warnmeldung ausgegeben wird, wenn anhand des Vergleichs auf einen bevorstehenden Ausfall geschlossen werden kann. Vergleich und Warnung können natürlich auch durch den Mikrocontroller 15 selbst vorgenommen werden.

Eine vergleichbare Messschaltung, wie sie in Fig. 2 dargestellt ist, kann zusätzlich sekundärseitig bei dem Schaltnetzteil der Fig. 1 angeordnet sein. Bei einer sekundärseitiger Messschaltung sind zwei erste Signalverarbeitungszweige 11 vorgesehen, um Spannungen U₇₀ bzw. U₇₅ und Ströme I₇₀ und I₇₅ über bzw. durch die sekundärseitigen Kondensatoren 70 bzw. 75 zu erfassen. Auf vergleichbare Art wie im Zusammenhang mit Fig. 4 beschrieben ist, wird von der sekundärseitigen Messschaltung ein Wert für einen Ersatzserienwiderstand ESR₇₀ bzw. ESR₇₅ der beiden sekundärseitigen (Sieb-)Kondensatoren 70 und 75 ermittelt. Die Mikrokontroller der primär- und der sekundärseitigen Messschaltungen können dabei über einen Datenkanal miteinander verbunden sein, um die Ergebnisse ggf. in einem Mikrocontroller zu sammeln und auszuwerten.

### Bezugszeichen

- 1: Schaltnetzteil
- 2: Leistungsfaktorkorrekturfilter
- 3: primärer Gleichrichter
- 4: primäre Siebstufe
- 40: Kondensator
- 41: Shunt
- 42-44: Messpunkt
- 5: Schaltwandler
- 50: Schalttransistor
- 51: Shunt
- 52-54: Messpunkt
- 55: Übertrager
- 6: sekundärer Gleichrichter
- 7: sekundäre Siebstufe
- 70: erster Sekundärkondensator
- 71: erster Shunt
- 72-74: Messpunkt
- 75: zweiter Sekundärkondensator
- 76: zweiter Shunt
- 77-79: Messpunkt
- 8: Filter

- 10: Messschaltung
- 11: erster Signalverarbeitungszweig (Kondensator)
- 111: Filter
- 112: Verstärker
- 12: zweiter Signalverarbeitungszweig (Schalttransistor)
- 121: Filter
- 122: Verstärker
- 123: Spannungsbegrenzungsschaltung
- 124: Synchronisationsschalter
- 13: Multiplexer
- 131: erster Umschalter
- 132: zweiter Umschalter
- 133: dritter Umschalter
- 14: Analog/Digital-Wandler
- 15: Mikrocontroller
- 151: Steuerleitung
- 152: Signaleingang
- 153: Datenausgang
- 16: Temperatursensor

- R1-R7: Widerstand
- D1: Diode
- OP1: Operationsverstärker

- U_{AC}: Netzspannung
- U_{DC}: Gleichspannung
- Uₑᵢₙ: Eingangsspannung
- Uₐᵤₛ: Ausgangsspannung
- V_{C}: positives Potential
- GND: Massepotential

## Patentansprüche

1. Messverfahren zur Überwachung eines Bauelements einer elektrischen Baugruppe, bei dem eine Spannung über mindestens einem Bauelement der elektrischen Baugruppe und ein Strom durch das Bauelement gemessen werden und bei dem aus Messwerten für Spannung und Strom ein Widerstandswert des Bauelements bestimmt wird, **dadurch gekennzeichnet, dass** die Spannung und der Strom nacheinander in aufeinanderfolgenden Schaltperioden eines periodischen Schaltsignals der elektrischen Baugruppe gemessen werden und der Widerstandswert anhand der Messwerte für Spannung und Strom aus den aufeinanderfolgenden Schaltperioden ermittelt wird.

2. Messverfahren nach Anspruch 1, bei dem die Spannung und der Strom synchron mit dem periodischen Schaltsignal der elektrischen Baugruppe gemessen werden, wobei der Widerstandswert anhand von Messwerten für Spannung und Strom bestimmt wird, die zu vergleichbaren Zeitpunkten innerhalb der aufeinanderfolgenden Schaltperioden gemessen sind.

3. Messverfahren nach Anspruch 1 oder 2, bei dem die elektrische Baugruppe ein Schaltnetzteil (1) und das Bauelement ein Schalttransistor (50) eines Schaltwandlers (5) des Schaltnetzteils (1) ist.

4. Messschaltung (10) zur Überwachung von Bauelementen einer elektrischen Baugruppe, aufweisend einen Analog/Digital-Wandler (14), der über einen Multiplexer (13) wahlweise zur Messung von Spannung über mindestens einem Bauelement oder zur Messung von Strom durch das Bauelement mit der elektrischen Baugruppe verbunden ist und die eingerichtet ist, ein Messverfahren nach einem der Ansprüche 1-3 auszuführen.

5. Messschaltung (10) nach Anspruch 4, aufweisend eine dem Multiplexer (13) vorgeschaltete Spannungsbegrenzungsschaltung (123) zur Begrenzung einer Eingangsspannung (Vₑᵢₙ) auf einen Maximalwert.

6. Messschaltung (10) nach Anspruch 4 oder 5, aufweisend eine Synchronisationseinrichtung, um Spannung und/oder Strom synchron mit einem periodischen Schaltsignal der elektrischen Baugruppe zu messen.

7. Messschaltung (10) nach Anspruch 6, die dazu eingerichtet ist, Spannung und Strom in aufeinanderfolgenden Schaltperioden des periodischen Schaltsignals zu messen und einen Widerstandswert anhand von Messwerten für Spannung und Strom zu bestimmen, die zu vergleichbaren Zeitpunkten innerhalb der aufeinanderfolgenden Schaltperioden gemessen sind.

8. Elektrische Baugruppe, aufweisend eine Messschaltung (10) nach einem der Ansprüche 4 bis 7 zur Messung eines Widerstandswerts eines Bauelements der elektrischen Baugruppe während des Betriebs der elektrischen Baugruppe.

9. Elektrische Baugruppe nach Anspruch 8, ausgebildet als ein Schaltnetzteil (1) mit einem Schaltwandler (5), wobei die Messschaltung (10) zur Messung eines Widerstands (Ron₅₀) eines Schalttransistors (50) des Schaltwandlers (5) eingerichtet ist.

10. Elektrische Baugruppe nach Anspruch 9, bei der die Messschaltung (10) zusätzlich zur Messung eines Ersatzserienwiderstands (ESR₄₀) eines Kondensators (40) einer primären Siebstufe (4) eingerichtet ist.

## Claims

1. A measurement method for monitoring a component of an electrical assembly, in which the voltage across at least one component of the electrical assembly and a current through the component are measured, and in which a resistance value of the component is determined on the basis of the measured values of voltage and current, **characterized in that** the voltage and the current are measured successively in successive switching periods of a periodic switching signal of the electrical assembly and **in that** the resistance value is determined on the basis of the measurements of voltage and current from the successive switching periods.

2. The measurement method according to claim 1, in which the voltage and the current are measured synchronized to the periodic switching signal of the electrical assembly, wherein the resistance value is determined on the basis of the measured values of voltage and current, which were measured at comparable times within successive switching periods.

3. The measurement method according to claim 1 or 2, in which the electric assembly is a switching power supply (1), and in which the component is a switching transistor (50) of a switching converter (5) of the switching power supply (1).

4. A measurement circuit (10) for monitoring components of an electrical assembly, including an analog/digital converter (14), which is connected to the electrical assembly via a multiplexer (13), so as to selectively measure the voltage across at least one component or the current through the same component, and which is arranged to perform a measurement method according to one of claims 1-3.

5. The measurement circuit (10) according to claim 4, including a voltage-limiting circuit (123) connected upstream of the multiplexer (13), which serves to limit an input voltage (Vₑᵢₙ) to a maximum value.

6. The measurement circuit (10) according to claim 4 or 5, including a synchronization device to measure voltage and/or current synchronized with a periodic switching signal from the electrical assembly.

7. The measurement circuit (10) according to claim 6, which is designed to measure voltage and current in successive switching periods of the periodic switching signal and to determine a resistance value on the basis of measured values of voltage and current, which were measured at comparable times within successive switching periods.

8. An electrical assembly including a measurement circuit (10) according to any one of claims 4 to 7 for measuring a resistance value of a component of the electrical assembly during the operation of the electrical assembly.

9. The electrical assembly according to claim 8, designed as a switching power supply (1) with a switching converter (5), wherein the measurement circuit (10) is designed to measure the resistance (Ron₅₀) of a switching transistor (50) of the switching converter (5).

10. The electrical assembly according to claim 9, in which the measurement circuit (10) additionally is designed to measure an equivalent series resistance (ESR₄₀) of a capacitor (40) of a primary filter stage (4).

## Revendications

1. Procédé de mesure pour la surveillance d'un élément d'un module électrique, dans lequel une tension parcourant au moins un élément du module électrique et une intensité dans l'élément sont mesurées et dans lequel une valeur de résistance de l'élément est déterminée à partir des valeurs de mesure de tension et d'intensité, **caractérisé en ce que** la tension et l'intensité sont mesurées successivement pendant des périodes de commutation successives d'un signal de commutation périodique du module électrique et la valeur de résistance est déterminée à l'aide des valeurs de mesure de tension et d'intensité des périodes de commutation successives.

2. Procédé de mesure selon la revendication 1, dans laquelle la tension et l'intensité sont mesurées de façon synchrone avec le signal de commutation périodique du module électrique, la valeur de résistance étant déterminée à partir des valeurs de mesure de tension et d'intensité qui sont mesurées à des moments comparables pendant les périodes de commutation successives.

3. Procédé de mesure selon la revendication 1 ou 2, dans lequel le module électrique est un bloc d'alimentation à découpage (1) et l'élément est un transistor de commutation (50) d'un convertisseur de commutation (5) du bloc d'alimentation à découpage (1).

4. Circuit de mesure (10) pour la surveillance d'éléments d'un module électrique, comportant un convertisseur analogique-numérique (14) qui est connecté sélectivement au module électrique par l'intermédiaire d'un multiplexeur (13) en vue soit de la mesure de la tension parcourant au moins un élément, soit de la mesure de l'intensité parcourant l'élément et qui est configuré pour exécuter un procédé de mesure selon l'une des revendications 1 à 3.

5. Circuit de mesure (10) selon la revendication 4, comprenant un circuit limiteur de tension (123) monté en amont du multiplexeur (13) pour limiter une tension d'entrée (Vₑᵢₙ) à une valeur maximale.

6. Circuit de mesure (10) selon la revendication 4 ou 5, comprenant un dispositif de synchronisation afin de mesurer la tension et/ou l'intensité de façon synchrone avec un signal de commutation périodique du module électrique.

7. Circuit de mesure (10) selon la revendication 6, configuré pour mesurer la tension et l'intensité pendant des périodes de commutation successives du signal de commutation périodique et déterminer une valeur de résistance à partir de valeurs de mesure de tension et d'intensité mesurées à des moments comparables pendant les périodes de commutation successives.

8. Module électrique comportant un circuit de mesure (10) selon l'une des revendications 4 à 7 pour la mesure d'une valeur de résistance d'un élément du module électrique pendant le fonctionnement du module électrique.

9. Module électrique selon la revendication 8, conçu comme un bloc d'alimentation à découpage (1) avec un convertisseur de commutation (5), dans lequel le circuit de mesure (10) est configuré pour mesurer une résistance (Ron₅₀) d'un transistor de commutation (50) du convertisseur de commutation (5).

10. Module électrique selon la revendication 9, dans lequel le circuit de mesure (10) est configuré en complément pour mesurer une résistance de substitution (ESR₄₀) d'un condensateur (40) d'un étage de filtrage primaire (4).
